# EUROPÄISCHE PATENTANMELDUNG

(11) **EP 1 193 873 A2**
(43) Veröffentlichungstag der Anmeldung: **03.04.2002**
(21) Anmeldenummer: 01123035.6
(22) Anmeldetag: 26.09.2001
(51) Int. Cl.: H03K 19/003, H03K 19/0185

(54) **Treiberschaltung für PC-Bus**

(30) Priorität: 29.09.2000 DE 10048823
(71) Anmelder: Melexis GmbH, 99097 Erfurt (DE)
(72) Erfinder: Herre, Sabine, 99099 Erfurt (DE); Rocznik, Marko, 71701 Schwieberdingen (DE)

(57) **Zusammenfassung**

Schaltungsanordnung eines dem USB-Standard entsprechenden in CMOS-NWELL-Technologie herstellbaren Low-Speed-Treibers für einen PC-Bos. Ein Schaltungsteil ermittelt die Flankensteilheit der Datenleitung mit der fallenden Flanke und regelt diese. Eine weitere Teilschaltung versetzt die Regelung beschleunigt in den Arbeitszustand. Aus dem Ergebnis der Regelung der Datenleitung mit fallender Flanke wird die Information zur Steuerung der Datenleitung mit steigender Flanke gewonnen. Die durch die Außenbeschaltung erzeugte Unsymmetrie des USB wir durch angepaßte Übertragung der Regelströme ausgeglichen.

## Beschreibung

Die Erfindung betrifft eine Schaltungsanordnung für die Regelung eines differentiellen Low-Speed-Treibers für den PC-Bus, der dem USB-Standard (Universal Serial Bus Specification Revision 1.1, 23.09.98) entspricht.

Differentielle Treiber zur Umwandlung relativ schwacher Eingangssignale in identische, verstärkte Signale zum Treiben von Übertragunsleitungen sind bekannt. Es wurde gemäß DE 197 15 455 bereits eine Schaltungsanordnung für einen bidirektionalen differentiellen Treiber für einen PC-Bus, der dem USB-Standard Specification Revision 1.0, 19.01.96 entspricht, vorgeschlagen. Die o. g. Schrift beschreibt zwei für den USB vorgesehene Treiberpinzipien, wovon eines ungeregelt und eines geregelt ist. Da das ungeregelte Treiberprinzip stark technologieabhängig ist, schwanken die Treiberwerte in einem weiten Bereich. Für das zweite, geregelte Konzept, sind sehr schnelle Operationsverstärker mit einem geringen Offset erforderlich. Weiterhin sieht dieses geregelte Prinzip die separate Regelung der beiden Datenleitungen D+ und D- vor, was die Schaltung wiederum empfindlich gegen Technologieschwankungen werden lässt.

Der USB-Standard enthält u.a. eine Reihe Forderungen, die besonders die ökonomische Herstellung eines Low-Speed-Treibers schwierig macht. Hierzu zählt die Flankensteilheit von 75ns bis 300ns bei 200pF bis 600pF kapazitiver Last, die Anpassung (Matching) der Flankenanstiegszeit von 90% bis 111,11%, der Crossover (Schnittpunkt steigende Flanke DP/fallende Flanke DM, bzw. fallende Flanke DP/steigende Flanke DM) 1,3V bis 2,0V. Durch die vorgegebene unsymmetrische Außenbeschaltung (Pul-Up-Widerstand von 1,5kΩ an DM) werden die Flanke, die Anpassung und der Crossover Point stark beeinflusst. Die Flanken von DM und DP sollen aber weitestgehend symmetrisch sein. Hieraus erwachsen die besonderen Anforderungen an die Schaltung und eine dies realisierende Technologie.

Es ist Aufgabe der Erfindung, eine Schaltungsanordnung für die Low-Speed-Regelung eines differentiellen Treiber anzugeben, welcher den Forderungen der "Universal Serial Bus Specification" (USB-Standard) entspricht, die sich kostengünstig auf die Herstellung des Treibers auswirkt, eine verringerte Abhängigkeit seiner Eigenschaften vom Herstellungsprozess beinhaltet, sowie einen geringen Leistungsverbrauch aufweist.

Erfindungsgemäß wird die Aufgabe dadurch gelöst, dass ein Schaltungsteil die Flankensteilheit der Datenleitung mit der fallenden Flanke ermittelt und gezielt regelt. Eine weitere Teilschaltung versetzt die Regelung beschleunigt in den Arbeitszustand. Aus dem Ergebnis der Regelung der Datenleitung mit fallender Flanke wird die Information zur Steuerung der Datenleitung mit steigender Flanke gewonnen. Die resistive Unsymmetrie des USB wird durch eine angepasste Übertragung des geregelten Schaltungsteil für die Datenleitung mit fallender Flanke an den gesteuerten Schaltungsteil der Datenleitung mit steigender Flanke ausgeglichen. Diese neuartige Schaltung ist so aufgebaut, dass sie sich mit bekannten Schaltungsteilen zu einem kompletten USB-Transceiver kombinieren und in eine CMOS-NWELL-Technologie integrieren lässt.

Weitere Besonderheiten sind aus den Beschreibungen der in den Figuren enthaltenen Schaltungen und aus den Ansprüchen ersichtlich.

Es zeigt:
- **Fig.1**: die Außenbeschaltung am Bus für Low-Speed
und
- **Fig.2**: ein Blockschaltbild mit dem Grundprinzip der Flankenbegrenzung für den Signalabfall
und
- **Fig.3**: einen schematischen Schaltplan für das in Fig. 1 gezeigte Blockschaltbild
und
- **Fig.4**: die Schaltung der gesamten Low-Speed-Regelung mit eingezeichneten Spiegelstrompfaden

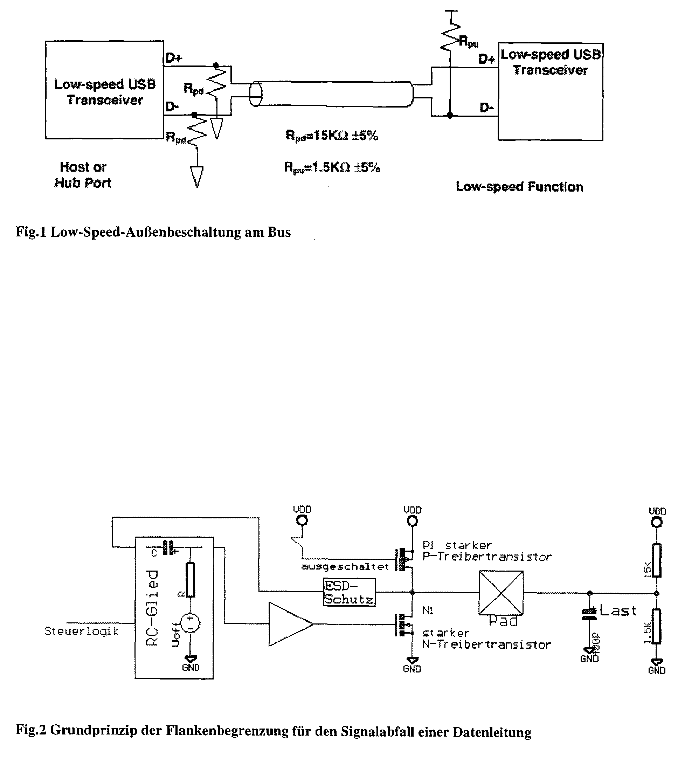

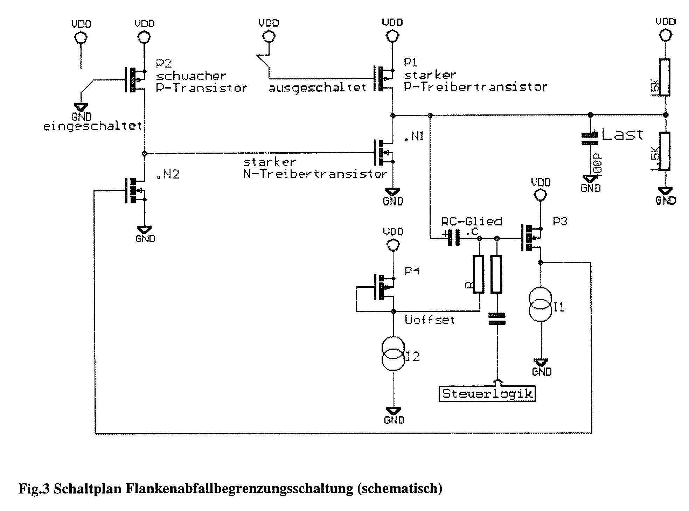

Fig.1 Zeigt die Außenbeschaltung des USB. Die Kapazität des dargestellten Kabels darf laut Spezifikation zwischen 200pF und 600pF betragen. Zusammen mit den Pull-Up- und Pull-Down-Widerständen ergibt sich damit eine resistive Unsymmetrie auf dem Bus.

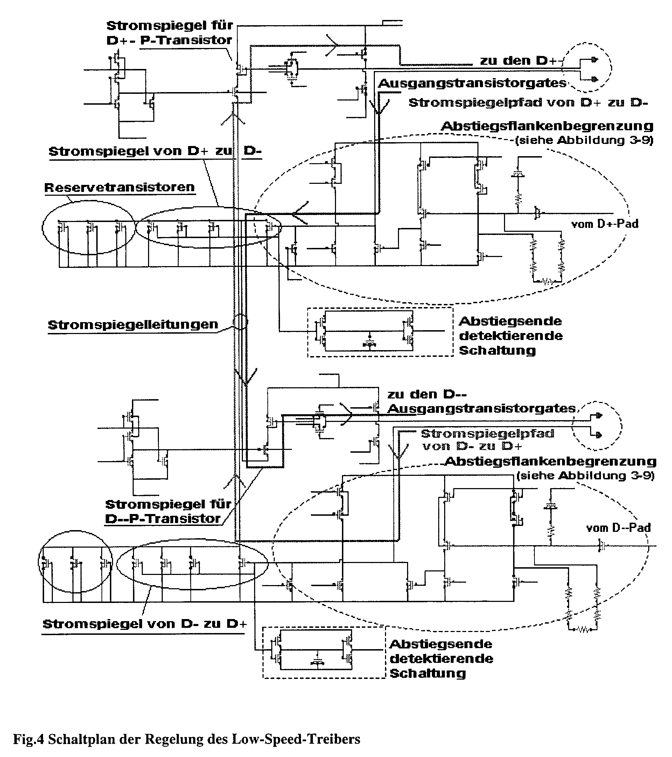

Deshalb wird für den Signalabfall das in Fig.2 gezeigte Prinzip zur Signalregelung verwendet. Bei diesem Prinzip wird der N-Kanaltransistor geregelt und der Strom für den P-Kanaltransistor der andern Datenleitung aus dem Ergebnis dieser Regelung gesteuert.

### • N-Kanaltransistorregelung:

Mit Hilfe eines RC-Gliedes wird die Abfallrate der Ausgangsspannung ermittelt. Die entstehende RC-Spannung wird verstärkt und zur Steuerung der Ausgangstransistoren eingesetzt. Fig.2 zeigt dies für die Regelung des Signalabstieges. Die digitale Steuerlogik schaltet den P-Kanal-Ausgangstransistor ab- und die Regelung für den N-Kanaltransistor ein. Da die Ausgangsspannung im ersten Moment nicht abfällt, liegt am Eingang des Regelverstärkers die volle Offsetspannung (Fig.2, U_{off}) des RC-Gliedes an. Diese Offsetspannung ist so eingestellt, dass sie in etwa der Schwellspannung des Regelverstärkereingangstransistors ent-spricht, ohne diesen jedoch zu öffnen. Daraus folgt, dass das Gate des N-Kanal-Ausgangstransistors aufgesteuert und die Kabelkapazität entladen wird. Durch diesen Spannungsabfall wird über das RC-Glied die Eingangsspannung des Regelverstärkers erniedrigt, so dass die Aufsteuerung des N-Ausgangstransistors zurückgenommen wird. Auf diese Art und Weise stellt sich ein geregelter Zustand ein der die Ausgangsspannung linear abnehmen lässt. Nach Beendigung des Flankenwechsels wird der N-Ausgangstransistor vollkommen aufgeregelt, da kein Signalabfall mehr stattfindet.

Fig.3 zeigt das Prinzipschaltbild auf Transistorlevel. Für den "High-Low"-Wechsel wird der obere P-Kanal-Ausgangstreibertransistor (P1) ab-geschaltet und es ist nur noch der N-Kanal-Ausgangstransistor (N1) in Betrieb, welcher die kapazitive Last entlädt und dem Pull-Up-Widerstand der Außenbeschaltung entgegenwirkt. Weiterhin ist P2 von der Steuerlogik eingeschaltet und zieht damit das Gate von N1 auf "High".

Vor dem Flankenwechsel liegt am Gate von P3 die gleiche Spannung wie am Drain von P4 an (entspricht der o.g. Offsetspannung U_{off} aus Fig.2). Diese Spannung entspricht in etwa der Schwellspannung von P3, ist aber so gewählt, dass dieser noch ausgeschaltet ist.

Durch den leitend werdenden Ausgangstransistor N1 wird die Lastkapazität entladen, womit der Spannungsabstieg beginnt. Dabei wird über das RC-Glied das Gate von P3 "negativer gezogen" und dieser leitend. Dadurch steigt die Gatespannung von N2, welcher seinerseits wiederum dem eingeschalteten P2 entgegenwirkt. Die Gatespannung des Ausgangstransistors N1 sinkt und es stellt sich ein geregeltes Verhältnis für den Flankenabstieg ein.

Um bei Signalbeginn die Anlaufverzögerung der Regelung so kurz wie möglich zu halten, wird das Gate von P3 über einen Kondensator und Widerstand schnell in die Nähe des Arbeitspunktes der Regelung gebracht. Kapazität und Widerstand sind so dimensioniert, dass diese "Starthilfe" mit angepasster Wirkung nur so lange wirkt, bis die Regelung eingesetzt hat. Das von der Steuerlogik (Fig. 3) gesteuerte Signal schaltet im selben Moment von "High" nach "Low", wie der Flankenwechsel beginnt.

### • P-Ausgangstransistorsteuerung:

Die Datenleitungen im USB-Kabel sind gleich lang und liegen dicht beieinander. Ihre Kapazitäten sind daher in guter Näherung gleich groß. Das nutzt die Schaltung nach Fig.4 und spiegelt den Strom durch den N-Kanal-Ausgangstransistor auf den P-Kanal-Ausgangstransistor der anderen Datenleitung.

In den Ellipsen aus Fig.4 ist die erweiterte Schaltung von Fig.3 zu erkennen. Die in den Kreisen dargestellten Pins führen zu den Transistorgates der Ausgangstransistoren ähnlich Fig.2. Die Padspannung wird über eine ESD-Schutzbeschaltung (wie in Fig.2 dargestellt) wieder zurück auf ein RC-Glied geführt und wie zuvor dargestellt zur Regelung des N-Ausgangstransistors benutzt. Die Gatespannung des N-Kanal-Ausgangstransistors wird zur Spiegelung des Stromes durch diesen auf den P-Ausgangstransistor der anderen Datenleitung verwendet.

Die Unsymmetrie durch die Außenbeschaltung des USB ist durch die Anpassung der Stromspiegelung weitestgehend kompensiert. Da die Dimensionierung der Spiegeltransistoren die Lage des Crossover Point bestimmt, sind sie auf mehrere Einzeltransistoren aufgeteilt und im Layout mehrere "Reservetransistoren" so daneben gelegt, dass durch Änderung einer Metallebene die Weite der Stromspiegeltransistoren kostengünstig geändert werden kann.

Die rechteckig eingerahmten Schaltungsteile in Fig.4 stellen Verzögerungsglieder dar, welche an die Gates der N-Ausgangstransistoren angeschlossen sind. So lange die Gatespannung der N-Ausgangstransistoren unter der Schaltschwelle der Eingangsinverter dieser Verzögerungsschaltung liegt wird "Low" ausgegeben. Das ist der Fall für die Zeit, in der die Regelung aktiv ist. Ist der Signalwechsel beendet, so steigt die Gatespannung des aktiven N-Ausgangstransistors bis auf die Betriebsspannung an und schaltet den Inverter der Abstiegsende detektierenden Schaltung ein. Mit diesem Signal werden die Stromquellen der Abstiegsregelung nach beendetem Flankenwechsel mittels in der Fig.4 dargestellten Transistoren abgeschaltet. Die Verzögerung stellt sicher, dass die Stromquellen auch wirklich erst abgeschaltet werden, wenn sie nicht mehr benötigt werden. Eine (nicht dargestellte) Steuerlogik schaltet für den nächsten Signalwechsel die Stromquellen wieder ein. So ergibt sich ein minimaler Stromverbrauch für die Regelschaltung.

## Patentansprüche

1. Schaltungsanordnung für eine USB-Low-Speed-Treiber-Regelung für einen PC-Bus, **dadurch gekennzeichnet, dass** die Schaltungsanordnung bestehend aus Flankenregelung der fallenden Flanke, Flankensteuerung der steigenden Flanke und Logik-Schaltungen sowie weiteren für einen USB-Transceiver notwendigen, bekannten Schaltungsteilen zusammen verschaltet und in einer CMOS-NWELL-Technologie monolitisch integriert ausgeführt sind.

2. Schaltungsanordnung für einen in CMOS-Technologie herstellbaren Low-Speed-Treiber, der sich dadurch kennzeichnet, dass die Flankensteilheit der abfallenden Flanke geregelt und aus dem Ergebnis der Regelwerte die Steilheit des Anstieges der Datenleitung mit steigender Flanke gesteuert und die durch die Außenbeschaltung erzeugte Unsymmetrie des USB durch angepasste Übertragung der Regelströme ausgeglichen wird. Diese Schaltungsanordnung besteht aus den Schaltungsteilen RC-Glied mit Offset, Regelverstärker, Stromspiegelung zur Steuerung der Transistoren für die Flankensteuerung der anderen Datenleitung.

3. Schaltungsanordnung nach Anspruch 2, die zur Regelung des Flankenabfalls eine Schaltung benutzt, welche mit einem RC-Glied, dass mit einer Offsetspannung für einen nachgeschalteten Regelverstärker versehen ist, die Flankensteilheit ermittelt und mit dem Ergebnis die Steilheit der Flanke über einen Regelverstärker nachregelt und in einen CMOS-Technologie herstellbar ist.

4. Schaltungsanordnung nach Anspruch 2, welche über Stromspiegelung die Ergebnisse der Flankenregelung der einen Datenleitung für die Flankensteuerung der anderen Datenleitung derart vornimmt, dass die durch die Außenbeschaltung des USB verursachten Unsymmetrien ausgeglichen werden und in einen CMOS-Technologie herstellbar ist.

5. Schaltungsanordnung nach Anspruch 3, welche sich dadurch kennzeichnet, dass sie nach Beendigung des Flankenan- bzw. Abstieges die Stromquellen, gesteuert von den Ergebnissen der Regelschaltung, in der Regelung sowie Stromspiegelung abschaltet.

6. Schaltungsanordnung nach Anspruch 3 die **dadurch gekennzeichnet ist, dass** zur beschleunigten Einnahme des Regelzustandes eine Anordnung aus Widerstand und Kondensator benutzt wird, die von einem logischen Signal angesteuert ist, welches im Flankenstartmoment schaltet.

7. Eine wie zuvor beschriebene Schaltungsanordnung, bei der allerdings die ansteigende Flanke nach zuvor beschriebenem Prinzip geregelt und die abfallende Flanke aus den Ergebnis dieser Regelung gesteuert wird, mit allen hierzu nötigen Modifikationen.

8. Eine wie in den vorhergehenden Anspruechen beschriebene Schaltung, die generell fuer einen differentiellen Treiber einsetzbar ist .
